Europäisches Patentamt

European Patent Office

Office européen des brevets

(11) Publication number: **0 083 986**
**A2**

(12) **EUROPEAN PATENT APPLICATION**

(21) Application number: **83300113.4**

(22) Date of filing: **10.01.83**

(51) Int. Cl.³: **H 01 L 27/14**

(30) Priority: **13.01.82 JP 2684/82**

(43) Date of publication of application:
**20.07.83 Bulletin 83/29**

(84) Designated Contracting States:
**DE FR GB**

(71) Applicant: **FUJI XEROX CO., LTD.**
**No. 3-5, Akasaka 3-chome**
**Minato-ku Tokyo 107(JP)**

(72) Inventor: **Haruhiko, Moriguchi c/o Fuji Xerox Co. Ltd**
**Ebina Works No. 2274, Hongo**
**Ebina-shi Kanagawa(JP)**

(72) Inventor: **Masami Kurata c/o Fuji Xerox Co. Ltd.**
**Ebina Works No. 2274 Hongo**
**Ebina-shi Kanagawa(JP)**

(74) Representative: **Cooper, Derek Robert et al,**
**Marks & Clerk Alpha Tower Suffolk Street Queensway**
**Birmingham B1 1TT(GB)**

(54) Polychromatic image sensor.

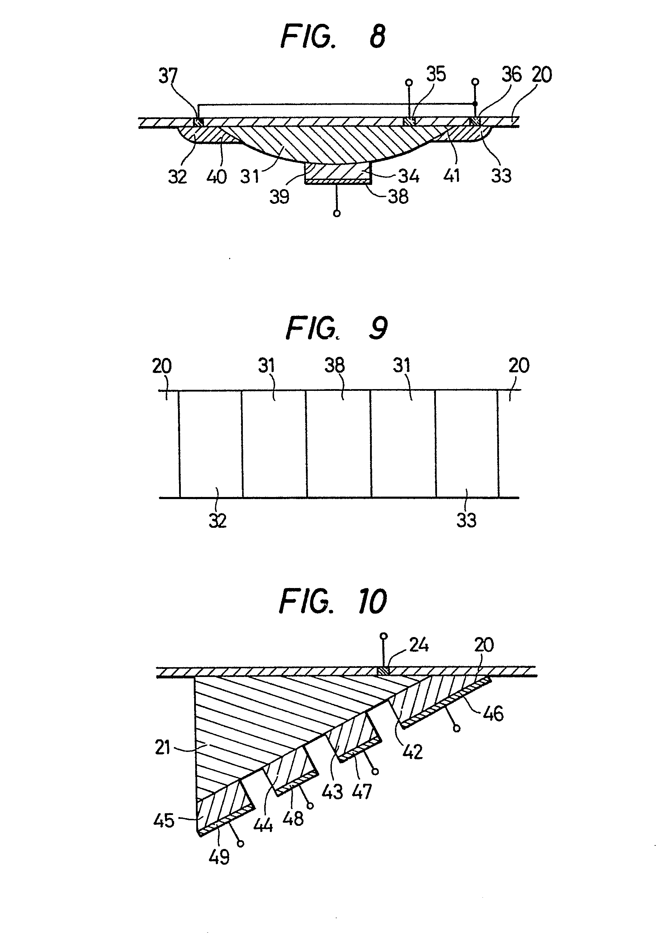

(57) A sensor has a light-receiving surface provided with a film 20 of silicon oxide, and beneath said film a region 21 of P-type semiconductor material. A plurality of regions 22,23 of N-type semiconductor material form with the region 21 respective PN-junctions 27,28 whose distance from the light-receiving surface varies continuously across or along the latter. Since the penetration of light into the regions 21, 22 and 23 will depend upon wavelength, the PN-junction 27 and 28 will provide different characteristics for different light wavelengths. The regions 22,23 may be disposed along a straight line, in which case the distance between the PN-junctions and the light-receiving surface can vary linearly along said line. Alternatively (Figure 8) the PN-junctions can be disposed on an arcuate surface so that their distance from the light-receiving surface varies non-linearly along said surfaces.

FIG. 6A

FIG. 6B

## "POLYCHROMATIC IMAGE SENSOR"

This invention relates to a photoelectric conversion element or image sensor used for an original document reading apparatus such as a facsimile system. In particular, the invention relates to a polychromatic image sensor having colour separation and reading capability for two or more colours.

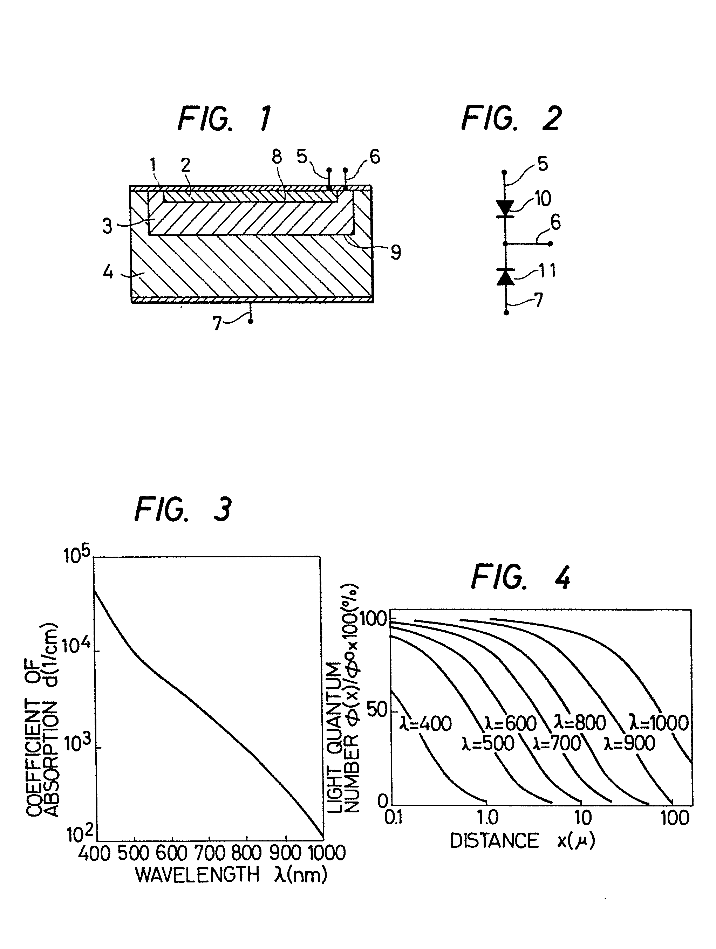

Figure 1 of the accompanying drawings illustrates a conventional polychromatic image sensor of the type mentioned above, which is composed of a film 1 of silicon oxide ($SiO_2$), a P-type diffusion region 2 (hereinafter referred to as a P-region), an N-type diffusion region 3 (hereinafter referred to as an N-region), and a second P-region 4. Electrode lead conductors 5, 6 and 7 are respectively led out from the P-region 2, the N-region 3 and the P-region 4. Reference numerals 8 and 9 denote first and second PN-junctions, respectively.

Figure 2 of the accompanying drawings is an equivalent circuit diagram of the polychromatic image sensor shown in Figure 1, wherein a photodiode 10 is defined by the P-region 2 and the N-region 3, and a photodiode 11 is defined by the N-region 3 and the P-region 4. The electrode lead conductor 6 is coupled to the junction between the respective cathodes of the photodiodes 10 and 11, while the electrode lead conductors 5 and 7 are led out from the anodes of the photodiodes 10 and 11, respectively.

The polychromatic image sensor of Figure 1 may have colour separation and reading capability, because when light of various frequencies impinges the silicon, the coefficient of absorption varies in the manner shown graphically in Figure 3 of the accompanying drawings. Consequently, there is a known relationship between wavelength of the light and the absorption into the silicon.

Figure 4 of the accompanying drawings is a graph showing for various wavelengths ($\lambda$) the percentage of light quanta which penetrate a distance $x$ into the silicon from the light-receiving surface of the latter. From Figures 3 and 4 it will be appreciated that, as the wavelength of the light decreases, the silicon absorbs light more effectively and that conversely, as the wavelength becomes longer, the greater the penetration into the silicon. Accordingly, it will be apparent from the configuration of the polychromatic image sensor that the first PN-junction 8 can be reached by light of short wavelengths as well as light of long wavelengths, while the second PN-junction 9 cannot generally be reached by short wavelength light, which will have been absorbed in the regions 2 and 3. Accordingly, information which includes short wavelength light can be obtained from the first photodiode 10, while information which excludes short wavelength light can be obtained from the second photodiode 11.

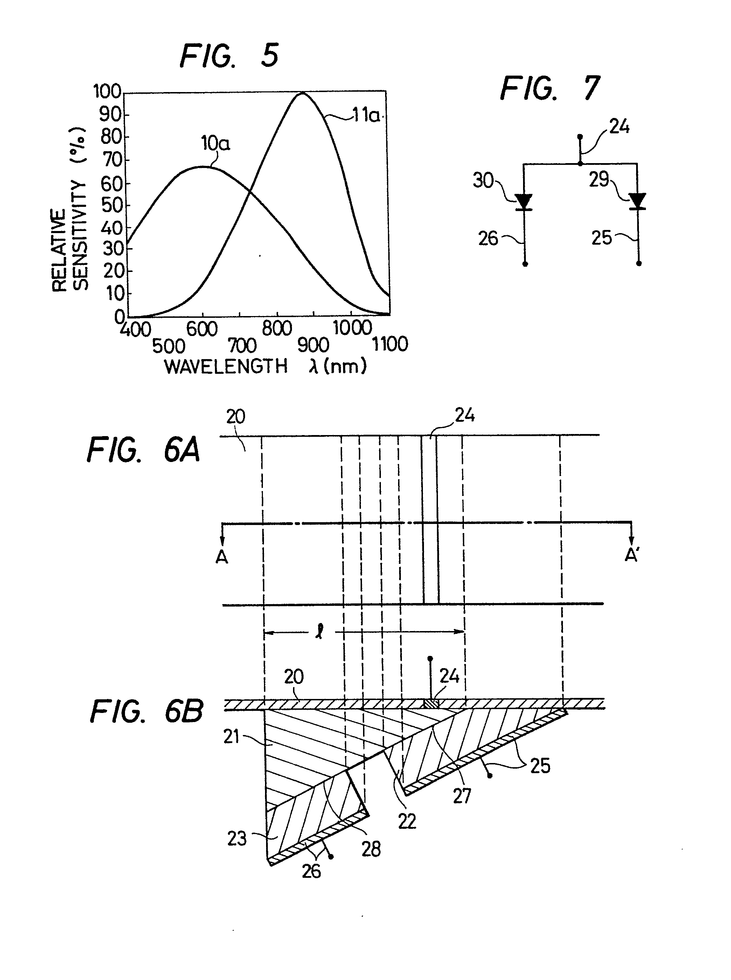

Characteristics as shown in Figure 5 of the accompanying drawings have been reported as obtained in the polychromatic image sensor shown in Figure 1. In Figure 5, curves 10a and 11a denote the characteristics of the first and second photodiodes 10 and 11, respectively. It will be seen from these characteristics that the first photodiode 10 has high sensitivity to short wavelength light and, on the contrary, the second photodiode 11 has high sensitivity to long wavelength light.

There is however a drawback in the polychromatic image sensor shown in Figure 1, in that the first and second PN-junctions 8 and 9 are formed in parallel with the silicon oxide film 1. More specifically, in order to obtain a polychromatic image sensor having the desired characteristics, it is necessary to form with precision the distance from the silicon oxide film to each of the first and second PN-junction planes, which is rather difficult. Moreover, it is also difficult to produce two or more PN-junctions accurately.

It is an object of the present invention to eliminate the above-described drawbacks of conventional polychromatic image sensors, and to provide a polychromatic image sensor in which the desired characteristics can be easily obtained and in which two or more PN-junctions can easily and accurately be produced.

Accordingly, the present invention provides a polychromatic semiconductor image sensor for converting an optical signal into an electrical signal, comprising a light-receiving surface, a region of a first semiconductor type formed below said light-receiving surface, and a plurality of regions of a second semiconductor type disposed relative to the first-mentioned region to define at least two PN-junctions, wherein the distance of the PN-junctions from the light-receiving surface varies continuously across or along the latter.

In a preferred aspect of the invention, a plurality of such sensors may be arrayed.

The invention will now be further described, by way of example only, with reference to the remaining Figures of the accompanying drawings, in which:-

Figure 6A is a plan view of a first embodiment of a sensor according to the present invention;

Figure 6B is a cross-sectional view taken along the line A-A' in Figure 6A;

Figure 7 is a diagram illustrating a circuit equivalent to the sensor shown in Figures 6A and 6B;

Figure 8 is a cross-sectional view of a second embodiment of a sensor according to the present invention;

Figure 9 is an underneath plan view of the sensor shown in Figure 8;

Figure 10 is a cross-sectional view of a third embodiment of a sensor according to the present invention;

Figure 11 is a diagram of a signal processing circuit to which a polychromatic image sensor according to the invention may be applied; and

Figure 12 is a graph showing the relationship between an output voltage of the circuit shown in Figure 11 and the wavelength of the light incident on the sensor, for explaining the chromatic or colour information which can be obtained from the circuit of Figure 11.

A first embodiment of the present invention is shown in Figures 6A and 6B, wherein the sensor comprises a film 20 of silicon oxide ($SiO_2$), a P-region 21, first and second N-regions 22 and 23 respectively, first to third electrodes 24 to 26 respectively, and first and second PN-junctions 27 and 28 respectively. The equivalent electrical circuit is shown in Figure 7, wherein a first photodiode 29 is defined by the P-region 21 and the N-region 22 and a second photodiode 30 is defined by the P-region 21 and the N-region 23.

In the thus arranged polychromatic image sensor, as is apparent from Figure 6B, the distance between the silicon oxide film 20 and the first PN-junction 27 is different from that between the silicon oxide film 20 and the second PN-junction 28. Accordingly, if light of differing wavelengths falls on the silicon oxide film, the wavelength distribution of the light which reaches the first PN-junction 27 will be different from that of the light whih reaches the second PN-junction 28. Consequently, the first and second photodiodes 29 and 30 differ from each other in relative sensitivity to the wavelengths, so that characteristics approximating to those shown in Figure 5 can be obtained.

The reason why such sensitivity can be obtained has been already described, and will therefore not be repeated here.

In producing the polychromatic image sensor described above; the length $\ell$ (being the dimension of the P-region 21 in a plane parallel to the film 20) selected to be 10 μm to 20 μm. In order to convert optical information from an original document into an electrical signal, the optical information is first compressed through an optical system, for example by a factor 0.2, and is then supplied to the polychromatic image sensor. This means, accordingly, that the information over a dimension of 50 μm to 100 μm on the original document is inputted into the polychromatic image sensor. Although the first and second PN-junctions 27 and 29 are laterally shifted, such a shift is effectively irrelevant because only a very small area of the document will be inputted to the polychromatic image sensor.

Figures 8 and 9 illustrate a second embodiment of the present invention, wherein the sensor comprises a film 20 of silicon oxide, a P-region 31, first to third N-regions 32 to 34 respectively, electrodes 35 to 38, a first PN-junction 39 and second PN-junctions 40 and 41. With particular reference to Figure 9, although shown as such it is not always necessary that the boundaries between the P-region and the N-regions extend in a straight line.

The sensor of this embodiment functions in a similar manner to the first embodiment, because the distance between the silicon oxide film 20 and the first PN-junction 39 is different from that between the silicon oxide film 20 and the second PN-junctions 40,41. However, the distance does not vary linearly as in the first embodiment, but rather varies continuously as a function of the radius of curvature defining the boundary of the P-region 31.

Figure 10 illustrates a third embodiment of the present invention which differs from the embodiment shown in Figures 6A and 6B in that four N-regions are provided, these being referenced 42 to 45 respectively. Reference numerals 46 to 49 designate respective electrodes for these N-regions. By increasing the number of N-regions and corresponding electrodes, the equivalent circuit will have a corresponding increased number of parallel branches.

It will be appreciated that the number of N-regions may be varied still further.

Each of the above-described embodiments of the invention has an advantage over conventional polychromatic image sensors, in that the distance from the silicon oxide film to the PN-junction does not have to be formed with a high degree of accuracy, since this distance gradually and continuously varies. Hence, strict coating tolerances in manufacture are not needed. There is a further advantage in that more than two PN-junctions can be easily made (for example as shown in Figure 10) so that light having various wavelength distributions can be converted into electrical signals.

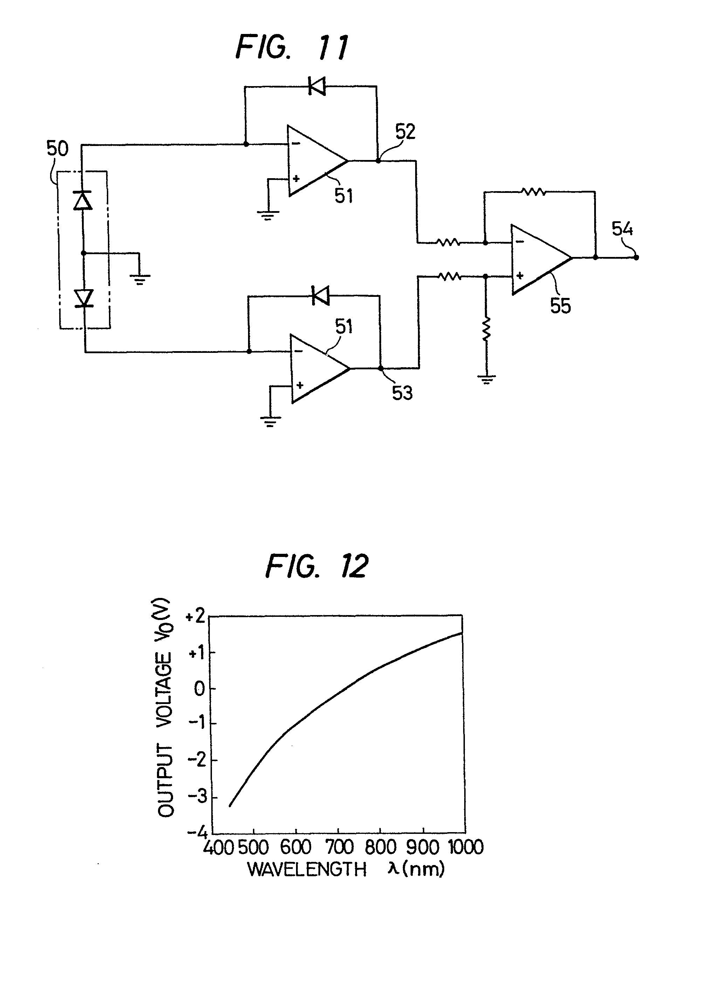

Figure 11 illustrates a circuit for processing electrical signals derived from a polychromatic image sensor according to the present invention. By way of example, the sensor shown in Figures 6A and 6B is utilised in Figure 11, being referenced 50. The output electrodes of the sensor 50 are each connected to the inverting input of a respective operational amplifier 51, the non-inverting input thereof being earthed. Each amplifier 51 has a diode connected in its feedback circuit. Output terminals 52 and 53 of the two amplifiers 51 are connected respectively to the inputs of a further operational amplifier 55, the latter having an output terminal 54. Light intensity information can be obtained from the terminals 52 and 53 as outputs from the respective diodes. Further, an output voltage $V_0$ which is a function of colour (i.e. colour information) can be obtained at the terminal 54. Figure 12 is a graph showing the relationship between the output voltage $V_0$ and the wavelength of the light incident on the sensor 50.

If a sensor is used with more than two PN-junctions, the number of amplifiers 51 will correspondingly be increased.

Although the above description refers to a single polychromatic image sensor, it will be appreciated that a plurality of such sensors may be disposed in an array, for example to be used as a line chromatic or colour sensor.

CLAIMS


1.    A polychromatic semiconductor image sensor for converting an optical signal into an electrical signal, comprising a light-receiving surface (20), a region (21; 31) of a first semiconductor type formed below said light- receiving surface 20, and a plurality of regions (22, 23; 32, 33; 42 to 45) of a second semiconductor type disposed relative to the first-mentioned region (21; 31) to define at least two PN-junctions (27, 28; 39,40,41), characterised in that the distance of the PN-junctions (27, 28; 39,40,41) from the light-receiving surface (20) varies continuously across or along the latter.


2.    A sensor as claimed in Claim 1, further comprising a silicon dioxide film (20) disposed on said light-receiving surface.


3.    A sensor as claimed in Claim 1 or 2, wherein said PN-junctions (27,28; 39,40,41) are disposed on a straight line between the region (21; 31) of said first semiconductor type and the plurality of regions (22,23; 32,33; 42 to 45) of said second semiconductor type, and wherein said distance of the PN-junctions (27,28; 39,40,41) from the light-receiving surface (20) varies linearly along said line.

4.    A sensor as claimed in Claim 1, 2 or 3, wherein said plurality of regions (22,23; 32,33; 42 to 45) of said second semiconductor type are spaced from each other.

5.    A sensor as claimed in Claim 1 or 2, wherein said PN-junctions (27,28; 39,40,41) are disposed on an arcuate surface between the region (21; 31) of said first semiconductor type and said plurality of regions (22,23; 32,33; 42 to 45) of said second semiconductor type, and said distance of the PN-junctions (27,28; 39,40,41) from the light-receiving surface (20) varies continuously and non-linearly along said surface.

6.    A sensor as claimed in any preceding claim, in combination with processing circuit means coupled to output electrodes of said sensor for producing first outputs indicative of light intensity distribution across said sensor and a second output indicative of the colour of the incident light.

FIG. 1

FIG. 2

FIG. 3

FIG. 4

COEFFICIENT OF ABSORPTION d(1/cm)

WAVELENGTH λ(nm)

LIGHT QUANTUM NUMBER φ(x)/φᵒ×100(%)

λ=400    λ=600    λ=800    λ=1000
    λ=500    λ=700    λ=900

DISTANCE x(μ)

FIG. 5

FIG. 7

FIG. 6A

FIG. 6B

FIG. 8

FIG. 9

FIG. 10

## FIG. 11

## FIG. 12